# EUROPÄISCHE PATENTSCHRIFT

(11) **EP 2 367 196 B1**
(45) Veröffentlichungstag und Bekanntmachung des Hinweises auf die Patenterteilung: **03.06.2015**
(21) Anmeldenummer: 11001998.1
(22) Anmeldetag: 10.03.2011
(51) Int. Cl.: H01J 37/34

(54) **Hohlkathoden-Plasmaquelle sowie Verwendung der Hohlkathoden-Plasmaquelle**
Hollow cathode plasma source and use of hollow cathode plasma source
Source plasma à cathodes creuses et utilisation de la source de plasma à cathodes creuses

(30) Priorität: 16.03.2010 DE 102010011592
(43) Veröffentlichungstag der Anmeldung: 21.09.2011
(73) Patentinhaber: Fraunhofer-Gesellschaft zur Förderung der angewandten Forschung e.V., 80686 München (DE)
(72) Erfinder: Jung, Thomas, 38173 Sickte (DE)
(74) Vertreter: Pfenning, Meinig & Partner GbR

(56) Entgegenhaltungen:
- DE-A1- 4 235 953
- DE-C1- 19 635 669
- US-A1- 2010 028 238

## Beschreibung

Die Erfindung betrifft eine Hohlkathoden-Plasmaquelle sowie die Verwendung der Hohlkathoden-Plasmaquelle. Die erfindungsgemäße Vorrichtung basiert auf der Grundlage des Hohlkathoden-Effektes, insbesondere wird sie zum Gasflusssputtern für die Beschichtung von Gegenständen mittels physikalischer Dampfabscheidung im Vakuum eingesetzt. Dabei betrifft die Erfindung insbesondere die Art und Weise der äußeren elektrischen Isolation der Kathode und der übrigen Bauteile, die das gleiche elektrische Potential führen.

In Hohlkathoden-Plasmaquellen erfolgt die PlasmaErzeugung durch eine Gasentladung, welche durch eine an die Hohlkathode angelegte elektrische Spannung verursacht wird.

Der plasmatechnisch wesentliche Teil der Hohlkathode ist ihre innere Oberfläche, d.h. jener Bereich der Oberfläche, der den Hohlraum bildet. Dieser Bereich wird für die Erzeugung der Hohlkathodenentladung verwendet.

Zusätzlich zu diesem inneren Bereich weist eine Hohlkathode jedoch weitere Oberflächenbereiche auf, die nach außen zeigen. Außerdem kann es Oberflächenbereiche geben, die zwar nach innen zeigen, aber nicht zur Hohlkathodenentladung beitragen sollen.

Weiterhin weisen Hohlkathoden-Plasmaquellen metallische Oberflächen auf; die ebenfalls das Kathodenpotential führen, beispielsweise weil sie mit der Kathode elektrisch verbunden sind, aber ebenfalls nicht zur Gasentladung beitragen sollen. Meist handelt es sich hierbei um Oberflächen von Bauteilen, die der mechanischen Halterung, der Kühlung oder der Stromversorgung der Hohlkathode dienen.

Ohne besondere Maßnahmen würden diese Oberflächenbereiche ebenfalls als Kathode von Gasentladungen wirken, d.h. zusätzliche Entladungen erzeugen. Das können gewöhnliche Glimmentladungen, Hohlkathoden-Glimmentladungen, gewöhnliche Bogenentladungen oder Hohlkathoden-Bogenentladungen sein.

Diese zusätzlichen Entladungen sind sehr nachteilig, weil sie unerwünscht Material abtragen, elektrische Energie verbrauchen, die Kathode und die anderen Bauteile zusätzlich erwärmen und zu schweren Instabilitäten der gewünschten Hohlkathodenentladung führen können.

Daher werden die genannten Oberflächenbereiche häufig durch eine Abschirmung abgedeckt, die ihre Funktion als Kathode einer Entladung unterbindet. Diese Abschirmung wird auch Gehäuse genannt und besteht gewöhnlich aus Metall, welches nicht in mechanischem Kontakt zur Kathode steht.

Gasflusssputter-(GFS-) Quellen mit Abschirm-Gehäuse, wobei die Kathode durch einen gasgefüllten Zwischenraum vom Gehäuse elektrisch isoliert ist, sind aus DE 42 35 953, DE 196 35 669 C1 und DE 102 27 048.1 bekannt.

Nachteilig bei DE 42 35 953 ist dabei, dass an den Rückseiten der Kathodenplatten, d.h. auf der Außenseite der Hohlkathode, eine zur gewünschten Hohlkathoden-Glimmentladung zusätzliche Entladung brennt, die unerwünscht Material abträgt, elektrische Energie verbraucht, die Kathode zusätzlich erwärmt und zu Instabilitäten des Plasmas durch die Entstehung von Bogenentladungen führt.

Auch wenn die Größe des Zwischenraumes so eng gewählt wird, dass eine Glimmentladung aus plasmaphysikalischen Gründen dort nicht stattfinden kann, ist die Neigung zu Bogenentladungen sehr groß, insbesondere bei einem Arbeitsdruck von mehr als 0,1 mbar.

Ein weiterer Nachteil besteht darin, dass es bereits durch geringe Maß-Veränderungen, beispielsweise verursacht durch ungleichmäßige Wärmedehnung von Kathode und Gehäuse, zu zufälligen Berührungen von Gehäuse und Kathode und damit zu Kurzschlüssen kommen kann.

Schließlich sind diese Erscheinungen dann besonders häufig, wenn das Gehäuse gleichzeitig als Anode dient, was zunächst vorteilhaft ist, da kein zusätzliches Bauteil für die Anode benötigt wird.

In der DE 42 35 953 ist eine GFS-Quelle angegeben, bei der allerdings nur ein Teil der Isolation der Kathode, und zwar die Stirnwände einer linearen GFS-Quelle, ebenfalls durch einen engen, gasgefüllten Spalt bewirkt wird. Alternativ kann dieser Spalt mit einem Isoliermaterial, wie Keramik und/oder Glas und/oder Glimmer, teilweise oder vollständig ausgefüllt werden.

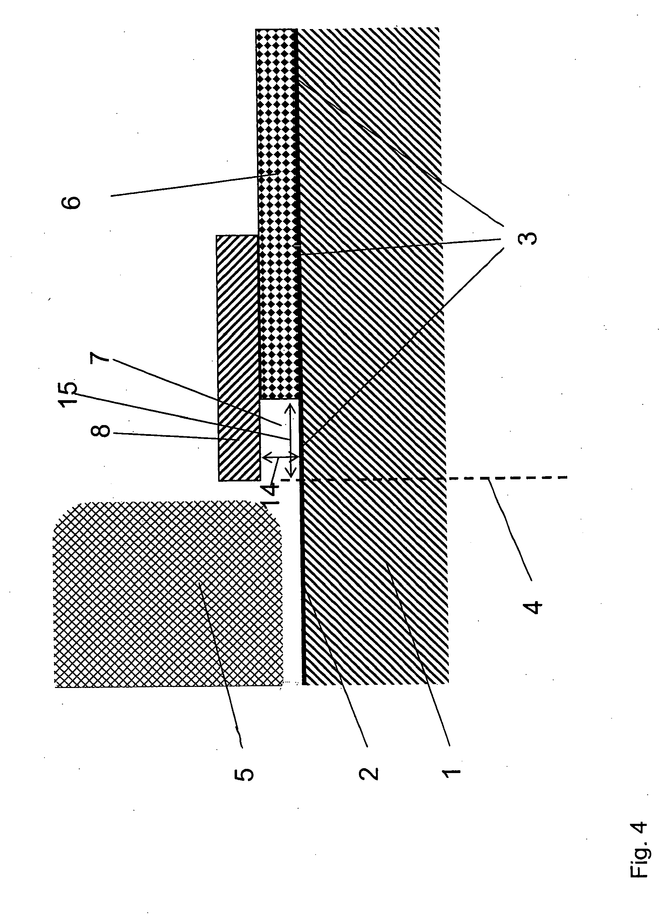

In der DE 42 35 953 wird in Spalte 2, Zeilen 58ff beschrieben, dass eine Weiterbildung der Erfindung vorsieht, dass statt der Isolierung durch Inertgas, d.h. durch den Spalt, dieser Spalt mit einem Isoliermaterial, wie Keramik und/oder Glas und/oder Glimmer, teilweise oder vollständig ausgefüllt wird, wobei die Anode nicht genauer spezifiziert ist. Figur 4 zeigt eine stabförmige Anode unterhalb des Inertgasverteilers. Nachteilig an dieser Lösung ist, dass für die Anodenfunktion ein zusätzliches Bauteil benötigt wird, dass die Anordnung unterhalb des Gasverteilers zwar die Beschichtung der Anode reduziert, aber eine größere Einbautiefe und ein wesentlich größeres Gewicht der gesamten GFS-Quelle bedingt, dass die Anodenoberfläche vergleichsweise klein ist und damit die Gefahr lokaler Überhitzungen und der Entstehung von Anoden-Bögen besteht, die zu schweren Plasma-Instabilitäten führen und die Anode zerstören können, dass die Anode direkt mit Wasser gekühlt werden muss, was einen erheblichen Zusatzaufwand darstellt, da sie ja gleichzeitig elektrisch isoliert sein muss, dass die Anode regelmäßig von Streubeschichtungen gereinigt werden muss und dass sich der Schwerpunkt der Entladung vom zu beschichtenden Substrat/ Bauteil weg bewegt und damit die an der Substratoberfläche meist gewünschte hohe Beschichtungsgeschwindigkeit und hohe Plasmadichte verringert.

Wird der Spalt vollständig mit einem Isoliermaterial ausgefüllt, so resultiert als entscheidender Nachteil, dass der Isolierstoff an seinem Rand zum Plasma nach einiger Zeit beschichtet oder anderweitig durch das Plasma verändert und dadurch leitfähig wird. Dadurch kommt es zu Kurzschlüssen.

Ist der Spalt nur teilweise mit Isolierstoff ausgefüllt, so können die genannten Störungen, d.h. Kurzschlüsse und Plasma-Instabilitäten einschließlich der Zerstörung der Isolierkörper der Kathode an deren Zuleitungen, in gleicher Weise auftreten. Ob dies eintritt oder nicht, hängt von der genauen räumlichen Gestaltung des Isolierstoffes ab. Über die genaue räumliche Gestaltung wird in der DE 42 35 953 jedoch nichts offenbart.

Ausgehend hiervon ist es somit Aufgabe der vorliegenden Erfindung, eine Hohlkathoden-Plasmaquelle bereitzustellen, bei der kein unerwünschter Materialabtrag durch zusätzliche Entladungen erfolgt, durch die darüber hinaus elektrische Energie verbraucht und die Kathode unnötig erwärmt wird. Weiterhin sollen Kurzschlüsse, die bereits durch geringe Maßveränderungen, beispielsweise durch ungleichmäßige Wärmedehnung von Kathode und Gehäuse verursacht werden, unterbunden werden.

Diese Aufgabe wird durch die Hohlkathoden-Plasmaquelle mit den Merkmalen des Anspruchs 1 gelöst. Die Ansprüche 18 und 19 betreffen die Verwendung der Hohlkathoden-Plasmaquelle. Weitere vorteilhafte Ausführungsformen sind in den abhängigen Ansprüchen enthalten.

Erfindungsgemäß ist eine Hohlkathoden-Plasmaquelle mit einer Abschirmung der nicht für die Plasmaerzeugung genutzten Bereiche der Hohlkathode und der mit ihr elektrisch verbundenen Teile gegenüber dem Plasma, wobei die Hohlkathode für die Plasmaerzeugung genutzte Oberflächen (aktive Oberflächen) und für die Plasmaerzeugung nicht-genutzte Oberflächen (passive Oberflächen) aufweist und die passiven Oberflächen der Hohlkathode zumindest bereichsweise mit einer Abschirmung aus mindestens einer Isolierstofflage oder einer Abschirmung aus mindestens einer Isolierstofflage mit mindestens einer metallischen Schutzlage versehen sind, wobei im zur aktiven Oberfläche benachbarten Randbereich der passiven Oberfläche die Abschirmung unter Ausbildung eines Randspaltes zur passiven Oberfläche beabstandet ist.

Folglich weist die erfindungsgemäße Hohlkathoden-Plasmaquelle eine Abschirmung aller oder fast aller Bereiche der Kathode auf, die nicht zur Plasmaerzeugung beitragen oder durch Ionenbeschuss zerstäubt werden sollen, sowie aller anderen Bauteile der Hohlkathoden-Plasmaquelle, die ebenfalls das elektrische Potential der Kathode führen, gegenüber dem umgebenen freien, gasgefüllten Raum innerhalb der Vakuumkammer und insbesondere gegenüber dort befindlichen Plasmen.

Der Randspalt der erfindungsgemäßen Hohlkathoden-Plasmaquelle kann insbesondere zwischen der Isolierstofflage und der passiven Oberfläche durch eine Ausnehmung in der Isolierstofflage gebildet sein.

Dies ist insbesondere dann der Fall, wenn die Abschirmung ausschließlich aus mindestens einer Isolierstofflage gebildet ist.

Weiterhin kann der Randspalt zwischen der metallischen Schutzlage und der passiven Oberfläche gebildet sein, indem in diesem Bereich die Isolierstofflage entfernt ist.

Unter einer Hohlkathoden-Weite ist erfindungsgemäß bei runden röhrenförmigen Hohlkathoden der innere Durchmesser der Hohlkathode zu verstehen. Die Hohlkathoden-Weite bei linearen Hohlkathoden, die aus zwei Platten gebildet sind, entspricht insbesondere dem Abstand zwischen den zwei Platten.

In einer bevorzugten Ausführungsform der erfindungsgemäßen Hohlkathoden-Plasmaquelle ist eine Spaltweite als Abstand zwischen der Abschirmung und der nicht im Bereich des Randspalts vorliegenden passiven Oberfläche gewählt, die höchstens 8 mm, bevorzugt höchstens 2 mm und besonders bevorzugt gleich null ist.

Die Spaltweite ist dabei in Abhängigkeit des Druckes, der üblicherweise im Bereich von 2 mbar bis 0,2 mbar liegt, zu wählen. Die Spaltweite darf nicht zu groß gewählt sein, da sonst in diesem Bereich Raum für Entladungen vorliegt. Ein Abstand zwischen Kathode und Abschirmung bzw. eine Spaltweite von 0, d.h. Berührung von Abschirmung und der passiven Oberfläche ist bevorzugt.

Weiterhin kann der Randspalt der erfindungsgemäßen Hohlkathoden-Plasmaquelle eine Randspalt-Weite zwischen der Abschirmung und der passiven Oberfläche zwischen 0,5 mm und 8 mm aufweisen.

Bevorzugt weist der Randspalt der erfindungsgemäßen Hohlkathoden-Plasmaquelle eine Randspalt-Weite zwischen der Abschirmung und der passiven Oberfläche zwischen 0,5 mm und höchstens 30 % der Hohlkathoden-Weite, bevorzugt höchstens 20 % der Hohlkathoden-Weite, besonders bevorzugt 10 % der Hohlkathoden-Weite auf.

Weiterhin kann der Randspalt eine Randspalt-Tiefe zwischen der Abschirmung und einem Lot, das zwischen der aktiven Oberfläche und der passiven Oberfläche gefällt ist, aufweisen, die mindestens den einfachen Wert, bevorzugt mindestens den eineinhalbfachen Wert, besonders bevorzugt den mindestens zweifachen Wert der Randspalt-Weite aufweist.

Diese Maße betreffen v.a. die Mindestentfernung zum Rand von allen Punkten, an denen die Isolierstofflage die Kathodenoberfläche berührt.

Dabei weist die Randspalt-Tiefe höchstens den fünffachen, bevorzugt höchstens den dreifachen Wert der Randspalt-Weite auf.

Diese genannte Höchsttiefe des Randspaltes gilt dabei insbesondere für den Fall, dass die Metalllage gleichzeitig Anode ist, da sonst die Gefahr von Überschlägen zwischen Anode und Kathode durch den Randspalt hindurch wächst. Andernfalls kann der Randspalt auch beliebig tiefer sein.

Somit wird unterbunden, dass die Stirnseite der Isolierstofflage beschichtet oder durch das Plasma degradiert und damit leitfähig wird.

Die Abschirmung kann im Bereich des Randspalts einen stufigen oder stetigen Verlauf aufweisen, wobei die Randspalt-Weite einer mittleren Randspalt-Weite gleichzusetzen ist.

Dadurch wird erreicht, dass der Randspalt einerseits am äußersten Rand der Abschirmung genügend weit ist, um elektrische Kurzschlüsse zuverlässig zu vermeiden, die verursacht werden können durch eine hohe elektrische Feldstärke zwischen Kathode und Abschirmung oder durch Metallpartikel, die aus sich ablösenden Streubeschichtungen entstanden sind, oder durch Streubeschichtungen der Ränder der Kathode oder der Abschirmung, und andererseits gleichzeitig in einiger Entfernung vom Rand genügend eng, um eine elektrisch leitende Beschichtung oder eine durch das Plasma bewirkte elektrisch leitfähige Oberflächenveränderung der Isolierstofflage oder eine lokale Glimm- oder Bogenentladung, die zu Beschichtungen oder Oberflächenveränderungen der Isolierstofflage oder zu Plasma-Instabilitäten führen kann, zuverlässig zu unterbinden.

Weiterhin kann die Abschirmung mindestens einen Zusatzspalt aufweisen, der in Richtung eines Lots, das zwischen der aktiven Oberfläche und der passiven Oberfläche gefällt ist, geöffnet ist.

Dadurch wird erreicht, dass der Weg für einen Kurzschluss länger ist und dadurch eine höhere Spannung erfordert und dass in der Oberfläche der Isolierstofflage zusätzliche Bereiche vorhanden sind, die nicht beschichtet und durch das Plasma in ihren Isolationseigenschaften verändert werden können.

In der erfindungsgemäßen Hohlkathoden-Plasmaquelle kann die metallische Schutzlage auf der Isolierstofflage direkt aufliegen, d.h. sie gegebenenfalls vollflächig berühren.

Weiterhin kann zwischen der metallischen Schutzlage und der Isolierstofflage ein Abstand im Bereich von 2 mm bis 10 mm vorliegen. Der Abstand kann dabei in Abhängigkeit vom Druck gewählt werden.

Bevorzugt ist auf der Isolierstofflage zusätzlich eine Anode, mit einem Abstand von mindestens 1 mm zur metallischen Schutzlage, angeordnet. Dadurch können intensive Entladungen im Randbereich der Abschirmung unterbunden werden, die sonst die Isolation bzw. Abschirmung beschädigen würden.

Vorzugsweise ist die Anode von der metallischen Schutzlage elektrisch isoliert angeordnet. Ebenso ist es möglich, dass die metallische Schutzlage mit der Anode elektrisch verbunden ist.

Es ist vorteilhaft, die metallische Schutzlage oder die Vakuumkammer oder beide mit der Anode elektrisch zu verbinden und sie damit gleichzeitig als Anode zu verwenden, weil dann kein zusätzliches Bauteil als Anode benötigt wird.

Dies ist außerdem vorteilhaft, weil die metallische Schutzlage und die Vakuumkammer meist eine große äußere Oberfläche aufweisen und damit eine räumlich gleichmäßige Funktion der Hohlkathode unterstützen und lokale Erwärmungen durch auftreffende Elektronen vermieden werden können und somit keine Kühlung erforderlich ist.

Die Verwendung der metallischen Schutzschicht als Anode ist vorteilhaft, weil sie sich meist in unmittelbarer Nähe der Hohlkathode befindet und dadurch einen geringen elektrischen Widerstand für den Entladungsstrom im Plasma ermöglichen, weil sie relativ gut gegen Streubeschichtungen geschützt sind und daher nicht aus diesem Grund gereinigt werden müssen.

Besonders vorteilhaft ist es, wenn zumindest der direkte Randbereich der metallischen Schutzlage von der Anode elektrisch isoliert ist, weil es dann nicht zu starken störenden Entladungen zwischen dem Rand der metallischen Schutzlage und der unmittelbar benachbarten Kathodenoberfläche kommen kann.

Das ist insbesondere bei hohem Gasdruck und geringem Abstand zwischen der Schutzlage und der benachbarten offen liegenden Kathodenoberfläche von Vorteil, vor allem dann, wenn außerdem der Randspalt durch die metallische Schutzlage und die Kathodenoberfläche gebildet wird, und nicht durch die Isolierstofflage.

Es ist weiterhin dann von besonderem Vorteil, wenn die Randspalt-Tiefe gering ist, weil in diesem Falle Überschläge zwischen Anode und Kathode schnell die im Spalt freiliegende Oberfläche der Isolierstofflage leitfähig machen können.

Die Aufgabe der metallischen Schutzlage ist es, die Isolierstofflage vor Beschichtung oder vor Beschädigung, Verschlechterung ihrer Isolationseigenschaften oder Zerstörung durch das Plasma oder durch Erwärmung zu schützen. Der Schutz vor Beschichtung betrifft alle Isolierstoffe, die übrigen Schutzfunktionen betreffen insbesondere Kunststoffe.

Eine weitere Aufgabe der metallischen Schutzlage ist es, kleine Fehlstellen in der Isolierstofflage abzudecken.

Schließlich ist es Aufgabe der metallischen Schutzlage, mittel- oder hochfrequente Wechselspannungs-Anteile im Potential der Kathode, die die Isolierstofflage ungehindert oder fast ungehindert durchdringen können, nach außen abzuschirmen.

In der erfindungsgemäßen Hohlkathoden-Plasmaquelle weist die Isolierstofflage eine Dicke von mindestens 0,05 mm, bevorzugt 0,5 mm bis 5 mm, besonders bevorzugt 1 mm bis 3 mm auf.

Die Isolierstofflage besteht bevorzugt aus einem dichten, sehr gut elektrisch isolierenden, möglichst wärmebeständigen Isolierstoff mit hoher chemischer Beständigkeit, hoher Formbeständigkeit und geringem Wasser- und Gasaufnahmevermögen.

Bevorzugt ist die Isolierstofflage ausgewählt aus Glas, Keramik, natürlichen Mineralien, insbesondere Glimmer, Kunststoff, bevorzugt Hochleistungskunststoff, besonders bevorzugt Teflon, Polyetheretherketon (PEEK), biaxial orientierter Polyesterfolie (boPET), Polyphenylensulfid (PPS), Polyphenylenether (PPE), Polyimiden, Hartpapier, Hartgewebe, körnigen Partikeln, pulverförmigen Partikeln und/oder Mischungen hiervon.

Die metallische Schutzlage kann eine Dicke von mindestens 0,05 mm, bevorzugt von 0,3 mm bis 20 mm, besonders bevorzugt von 0,5 bis 2 mm aufweisen.

Bevorzugt besteht die metallische Schutzlage aus Metall, insbesondere Aluminium, Titan, Kupfer, Nickel, Legierungen, insbesondere Chrom-Nickel-Stahl oder enthält dieses.

Erfindungsgemäß ist auch die Verwendung der zuvor beschriebenen Hohlkathoden-Plasmaquelle zur Oberflächenbehandlung von Hohlräumen und konkav geformten Oberflächen, insbesondere von Rohren und Lagern, von Bauteilen von Turbinen, Gasturbinen, Dampfturbinen, Verdichtern, insbesondere Schaufelblättern, Bauteilen von Verbrennungsmotoren und deren Abgassystemen, Katalysatoren, mikroelektronischen, mikromechanischen und medizintechnischen Bauteilen, Mikrobauelementen mit Piezotechnik, insbesondere Blei-Zirkonat-Titanat (PZT), medizinischen Implantaten, Dental-Implantaten, Solarzellen, amorphem Silicium (a-Si:H) sowie Hartstoffen für Werkzeuge.

Auch die Verwendung der zuvor beschriebenen Hohlkathoden-Plasmaquelle zur Herstellung von Metallschichten, Oxidschichten, Nitridschichten, kohlenstoffhaltigen Schichten, insbesondere für tribologische, elektrische, optische, elektromechanische, elektrooptische, medizinische und katalytische Anwendungen, als Barriere- und Korrosionsschutzschichten, transparentem Kratzschutz, transparente leitfähige Beschichtungen (TCO, transparent conductive coatings) sowie in Festoxidbrennstoffzellen (SOFC, solid oxid fuel cell) ist erfindungsgemäß.

Anhand der folgenden Figuren 1 bis 13 soll der anmeldungsgemäße Gegenstand näher erläutert werden, ohne diesen auf diese Varianten einzuschränken.

Es zeigt
- Figur 1: einen Ausschnitt von der Abschirmung und der Kathodenoberfläche der Hohlkathoden-Plasmaquelle, wobei hier der Randspalt durch eine Stufe in der Isolierstofflage gebildet ist.
- Figur 2: einen Ausschnitt von der Abschirmung und der Kathodenoberfläche der Hohlkathoden-Plasmaquelle, die eine metallische Schutzlage aufweist, wobei der Randspalt durch eine Ausnehmung in der Isolierstofflage entsteht.
- Figur 3: einen Ausschnitt von der Abschirmung und der Kathodenoberfläche der Hohlkathoden-Plasmaquelle, wobei der Isolierstoff durch eine Metalllage abgedeckt ist und der Randspalt durch die Isolierstofflage sowie die metallische Schutzlage gebildet ist.
- Figur 4: einen Ausschnitt von der Abschirmung und der Kathodenoberfläche der Hohlkathoden-Plasmaquelle, wobei die Isolierstofflage teilweise mit einer metallischen Schutzlage versehen ist und der Randspalt durch die Isolierstofflage sowie die metallische Schutzlage gebildet ist.
- Figur 5: einen Ausschnitt von der Abschirmung und der Kathodenoberfläche der Hohlkathoden-Plasmaquelle, wobei die Isolierstofflage teilweise eine metallische Schutzlage und, dazu beabstandet, eine Anode aufweist. Der Randspalt ist durch die Isolierstofflage sowie die metallische Schutzlage gebildet.
- Figur 6: einen Ausschnitt von der Abschirmung und der Kathodenoberfläche der Hohlkathoden-Plasmaquelle mit durchgängigem Spalt, d.h. der Randspalt geht stetig in die Spaltweite über.
- Figur 7: einen Ausschnitt von der Abschirmung und der Kathodenoberfläche der Hohlkathoden-Plasmaquelle, wobei die Isolierstofflage vollständig mit einer metallischen Schutzlage versehen ist.
- Figur 8: einen Ausschnitt von der Abschirmung und der Kathodenoberfläche der Hohlkathoden-Plasmaquelle, wobei die Isolierstofflage einen stufenförmigen Aufbau aufweist und vollständig mit einer metallischen Schutzlage versehen ist.
- Figur 9: einen Ausschnitt von der Abschirmung und der Kathodenoberfläche der Hohlkathoden-Plasmaquelle, wobei die Isolierstofflage mit einer metallischen Schutzlage versehen ist und die Isolierstofflage eine schräge Ausnehmung aufweist.
- Figur 10: einen Ausschnitt von der Abschirmung und der Kathodenoberfläche der Hohlkathoden-Plasmaquelle mit einer Isolierstofflage, die eine metallische Schutzlage aufweist, wobei in der Isolierstofflage ein Zusatzspalt angeordnet ist.
- Figur 11: einen Ausschnitt von der Abschirmung und der Kathodenoberfläche der Hohlkathoden-Plasmaquelle mit einer Isolierstofflage, wobei die Hohlkathoden-Oberfläche eine Stufe aufweist.
- Figur 12: einen Ausschnitt von der Abschirmung und der Kathodenoberfläche der Hohlkathoden-Plasmaquelle mit einer Abschirmung aus Isolierstofflage und metallischer Schutzlage, wobei sowohl die Hohlkathode als auch die Isolierstofflage jeweils eine Stufe aufweist.
- Figur 13: einen Querschnitt durch eine Hohlkathoden-Plasmaquelle, die eine Abschirmung aus Isolierstofflage mit metallischer Schutzlage aufweist.

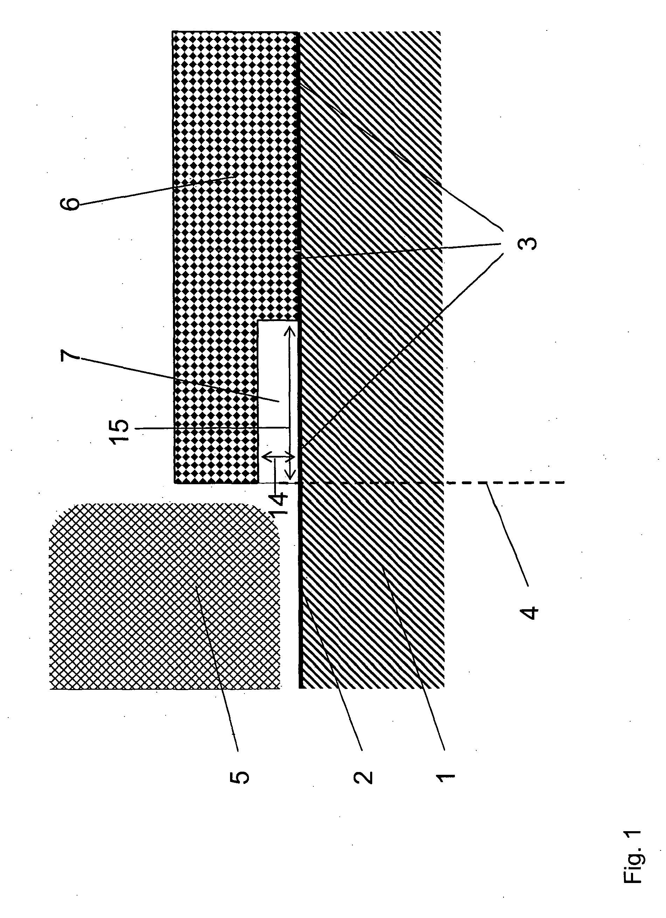

Figur 1 zeigt einen Ausschnitt einer Hohlkathoden-Plasmaquelle mit einer Hohlkathode 1, die auf ihrer passiven Oberfläche 3 eine Isolierstofflage 6 aufweist. Der Randspalt 7 ist zwischen der Isolierstofflage 6 sowie der passiven Oberfläche 3 ausgebildet. Dieser Abstand wird als Randspalt-Weite 14 bezeichnet. Der Abstand zwischen der Isolierstofflage 6 und dem Lot 4, das zwischen der aktiven und passiven Oberfläche gebildet ist, wird als Randspalt-Tiefe 15 bezeichnet. Benachbart zur aktiven Oberfläche 2 liegt das Plasma 5 vor. Die Randspalt-Tiefe 15 beträgt in dieser Variante das Vierfache der Randspalt-Weite 14.

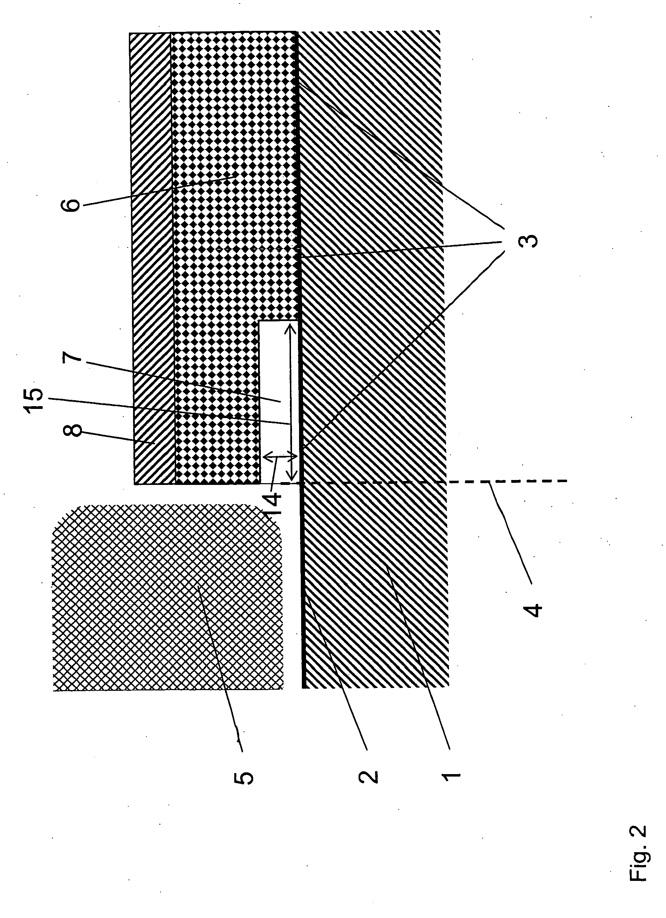

Figur 2 zeigt eine Variante, in der die passive Oberfläche 3 eine Isolierstofflage 6 aufweist, die vollständig mit einer metallischen Schutzlage 8 versehen ist. Der Randspalt 7 entsteht durch eine Ausnehmung in der Isolierstofflage 6. Die Randspalt-Tiefe 15 entspricht dem Abstand zwischen der Isolierstofflage 6 sowie dem Lot 4, das zwischen der aktiven Oberfläche 2 und passiven Oberfläche 3 gebildet ist. Die Randspalt-Weite 14 entspricht dem Abstand zwischen der Isolierstofflage 6 sowie der passiven Oberfläche 3. Benachbart zur aktiven Oberfläche 2 der Hohlkathode 1 liegt das Plasma 5 vor.

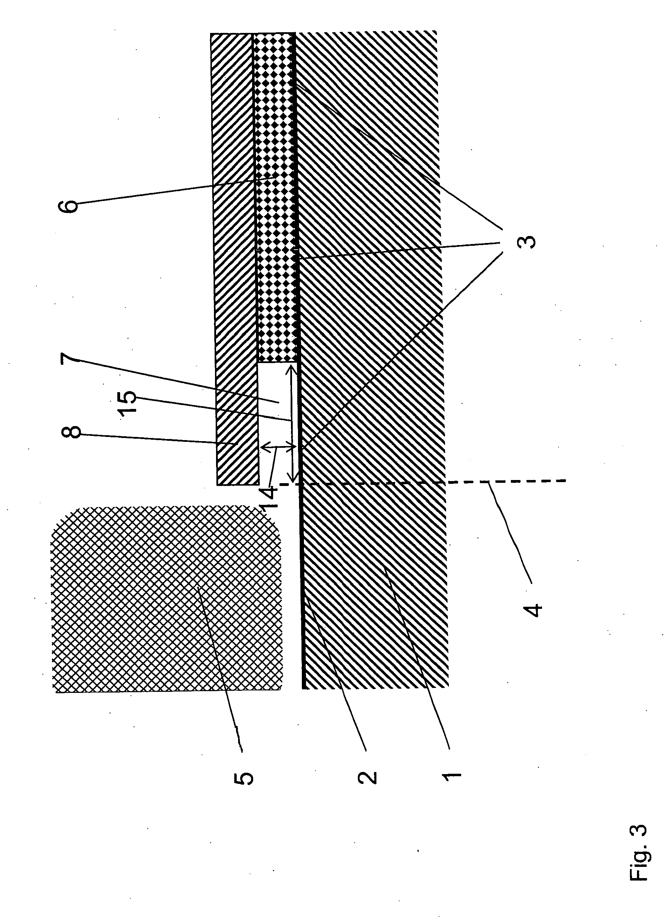

Figur 3 zeigt eine Ausführungsform, wobei die passive Oberfläche 3 bereichsweise mit einer Isolierstofflage 6 versehen ist, die eine metallische Schutzlage 8 aufweist. Der Randspalt 7 wird durch die Randspalt-Weite 14 zwischen der metallischen Schutzlage 8 und der passiven Oberfläche 3 sowie der Randspalt-Tiefe 15 zwischen der Isolierstofflage 6 und dem Lot 4 beschrieben. Die Randspalt-Tiefe 15 beträgt das Dreifache der Randspalt-Weite 14. Das Plasma 5 liegt neben der aktiven Oberfläche 2 der Hohlkathode 1 vor.

Figur 4 zeigt eine Abschirmung aus einer Isolierstofflage 6, die teilweise mit einer metallischen Schutzlage 8 versehen ist. Die Randspalt-Tiefe 15 ist zwischen dem Lot 4 und der Isolierstofflage 6 gebildet. Die Randspalt-Weite 14 entspricht dem Abstand zwischen der metallischen Schutzlage 8 von der passiven Oberfläche 3. Die Randspalt-Tiefe 15 beträgt das Doppelte von der Randspalt-Weite 14. Das Plasma 5 liegt an der aktiven Oberfläche 2 der Hohlkathode 1 vor.

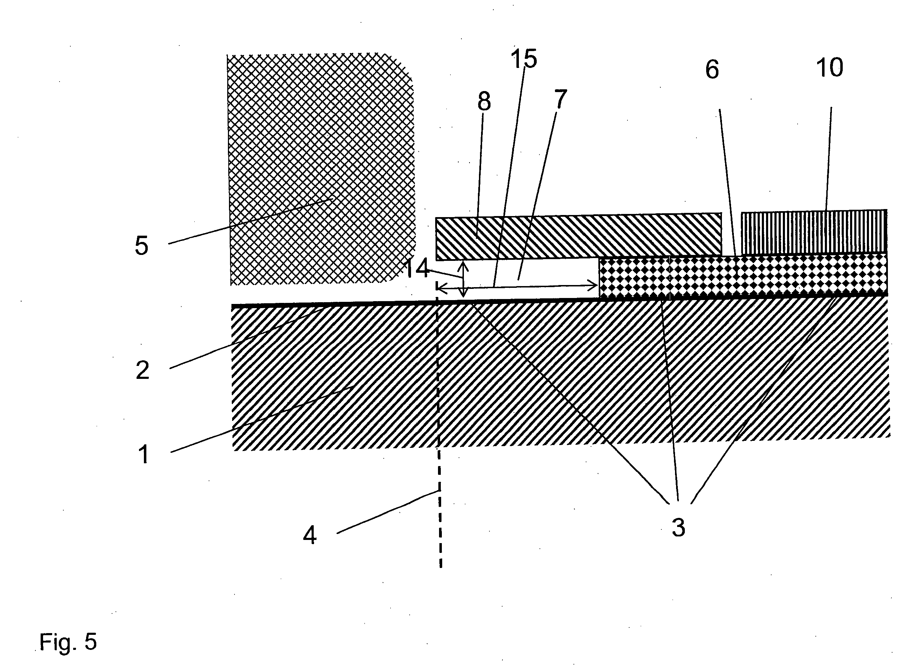

Figur 5 zeigt eine Ausführungsform, wobei die passive Oberfläche 3 bereichsweise mit einer Isolierstofflage 6 versehen ist, die sowohl mit einer metallischen Schutzlage 8 und, dazu beabstandet, mit einer Anode 10 versehen ist. Die Randspalt-Weite 14 entspricht dem Abstand zwischen der passiven Oberfläche 3 und der metallischen Schutzlage 8. Die Randspalt-Tiefe 15 entspricht dem Abstand zwischen der Isolierstofflage 6 sowie dem Lot 4, das zwischen der aktiven Oberfläche 2 und der passiven Oberfläche 3 gebildet ist. Das Plasma 5 liegt benachbart zur aktiven Oberfläche 2 der Hohlkathode 1 vor.

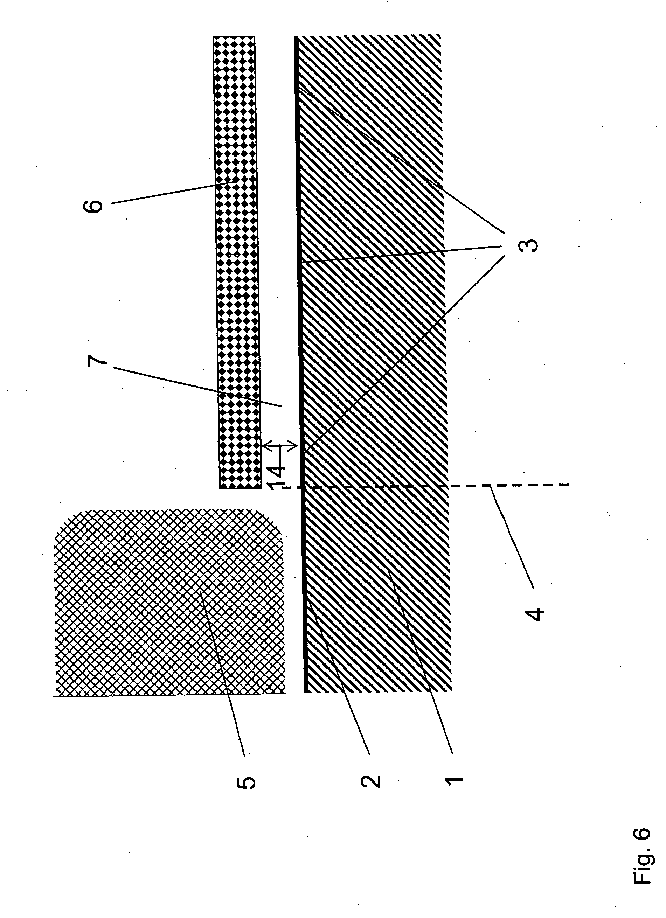

In Figur 6 ist eine Ausführungsform dargestellt, in der die Randspalt-Weite 14 stetig in die Spaltweite übergeht. Die Abschirmung besteht aus einer Isolierstofflage 6. Das Plasma 5 ist benachbart zur aktiven Oberfläche 2 der Hohlkathode 1.

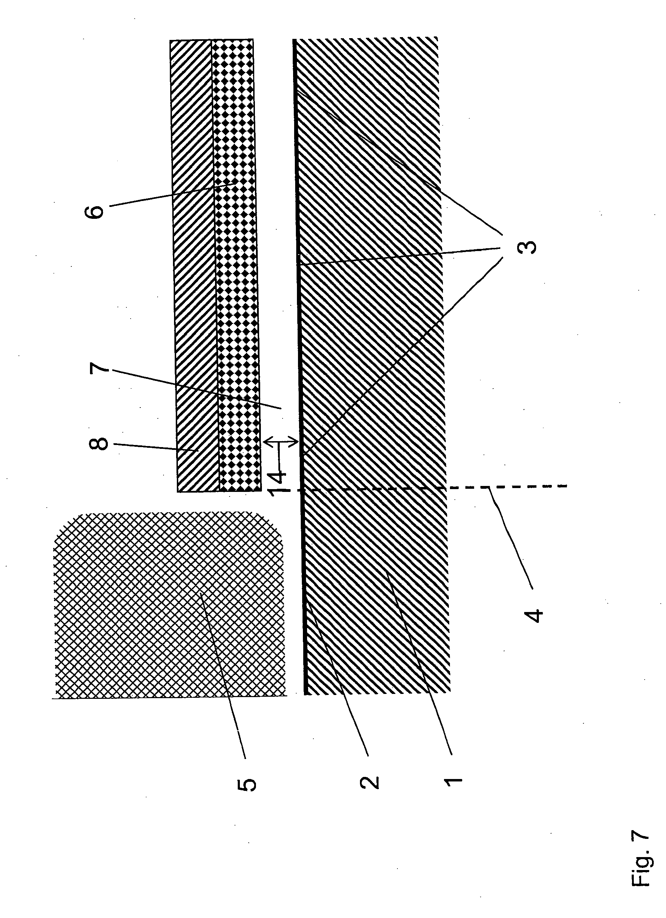

Figur 7 zeigt eine Abschirmung aus einer Isolierstofflage 6, die vollständig mit einer metallischen Schutzlage 8 versehen ist. Der Randspalt 7 mit einer Randspalt-Weite 14, die zwischen der Isolierstofflage 6 und der passiven Oberfläche 3 vorliegt, geht stetig in die Spaltweite über. Benachbart zur aktiven Oberfläche 2 der Hohlkathode 1 liegt das Plasma 5 vor.

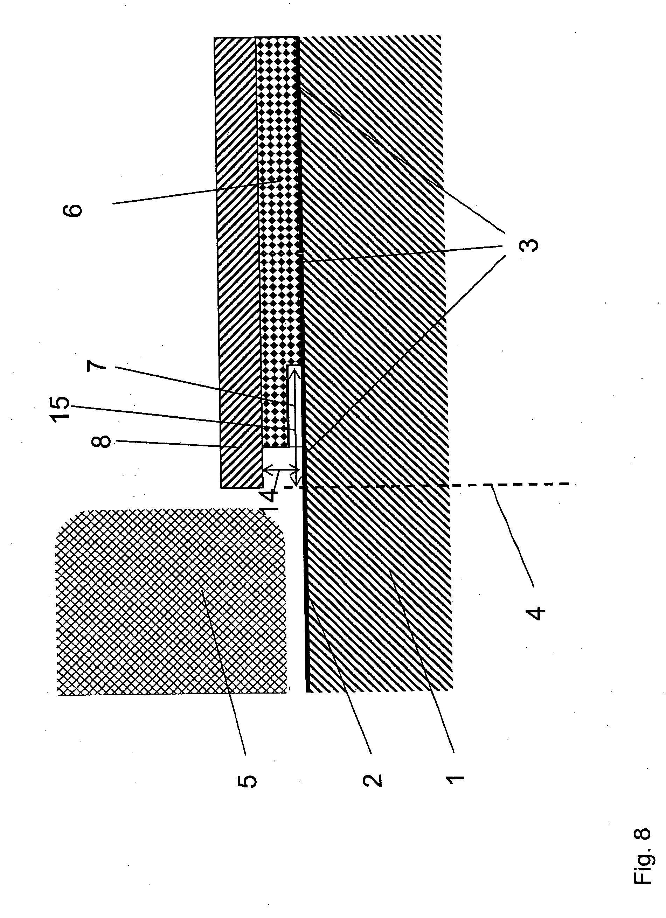

Figur 8 zeigt eine Hohlkathode 1, die auf ihrer passiven Oberfläche 3 bereichsweise eine stufenförmigaufgebaute Isolierstofflage 6 aufweist. Diese ist vollständig mit einer metallischen Schutzlage 8 versehen. Die Randspalt-Weite 14 entspricht dem Abstand zwischen der metallischen Schutzlage 8 und der passiven Oberfläche 3. Die Randspalt-Tiefe 15 entspricht dem Abstand zwischen dem Lot 4 und der Isolierstofflage 6. Neben der aktiven Oberfläche 2 der Hohlkathode 1 liegt das Plasma 5 vor. Die mittlere Randspalt-Tiefe 15 beträgt das 1,8-fache der Randspalt-Weite 14.

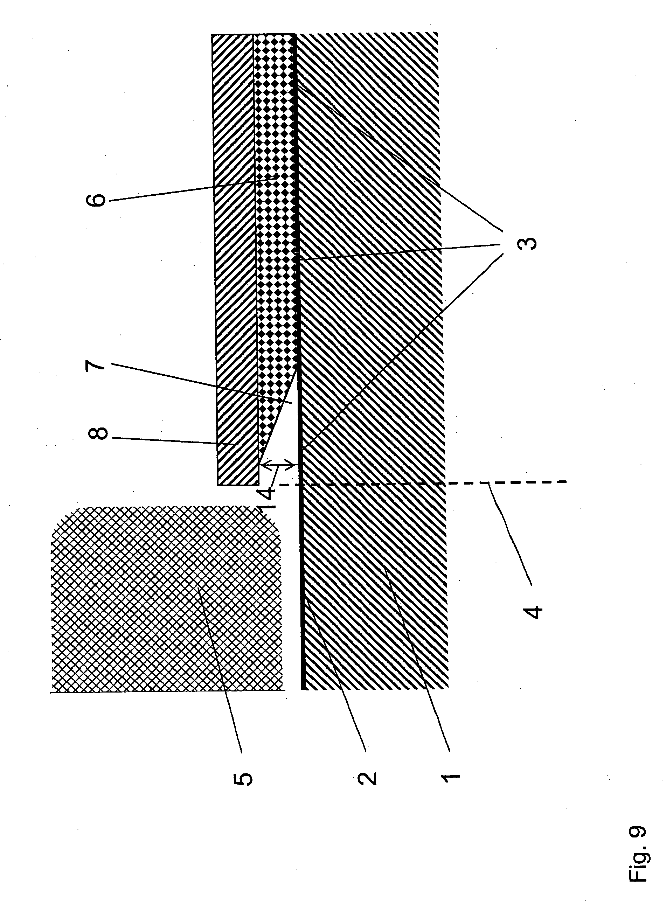

In Figur 9 ist die Abschirmung der passiven Oberfläche 3 durch eine Isolierstofflage 6 mit stetig zum Rand hin wachsender Randspalt-Weite 14 gebildet. Auf der Isolierstofflage 6 liegt eine metallische Schutzlage 8 vor. Die Randspalt-Weite 14 entspricht dem Abstand zwischen metallischer Schutzlage 8 und passiver Oberfläche 3. Die mittlere Randspalt-Tiefe 15 beträgt das 1,75-fache der Randspalt-Weite 14. Benachbart zur aktiven Oberfläche 2 der Hohlkathode 1 liegt das Plasma 5 vor.

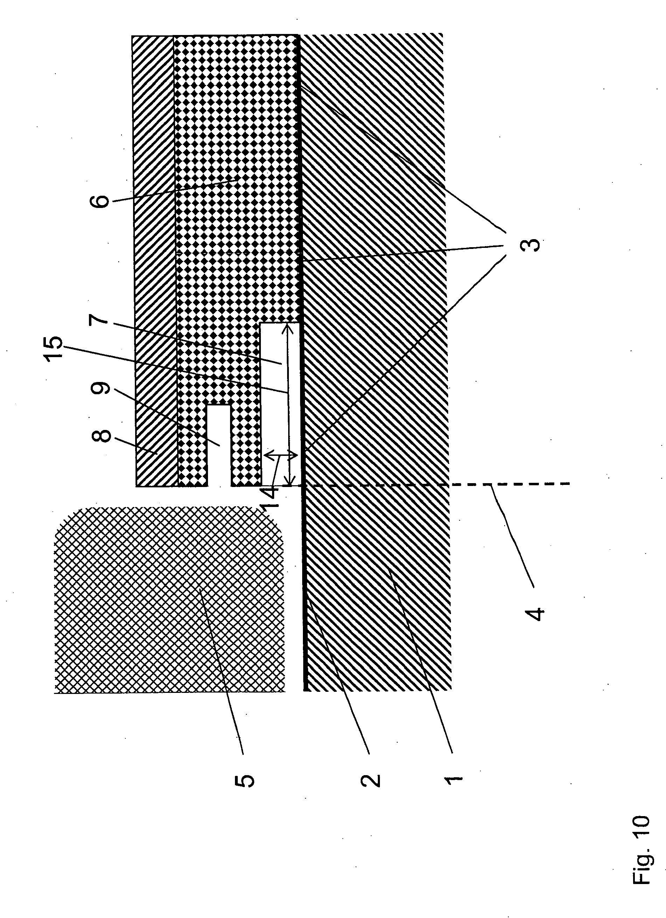

In Figur 10 ist eine Abschirmung aus einer Isolierstofflage 6 mit einem Spalt 7 und einem Zusatzspalt 9 dargestellt. Die Isolierstofflage 6 ist vollständig mit einer metallischen Schutzlage 8 versehen. Die Randspalt-Weite 14 entspricht dem Abstand zwischen der Isolierstofflage 6 und der passiven Oberfläche 3. Die Randspalt-Tiefe 15 entspricht dem Abstand zwischen der Isolierstofflage 6 und dem Lot 4. Benachbart zur aktiven Oberfläche 2 der Hohlkathode 1 liegt das Plasma 5 vor.

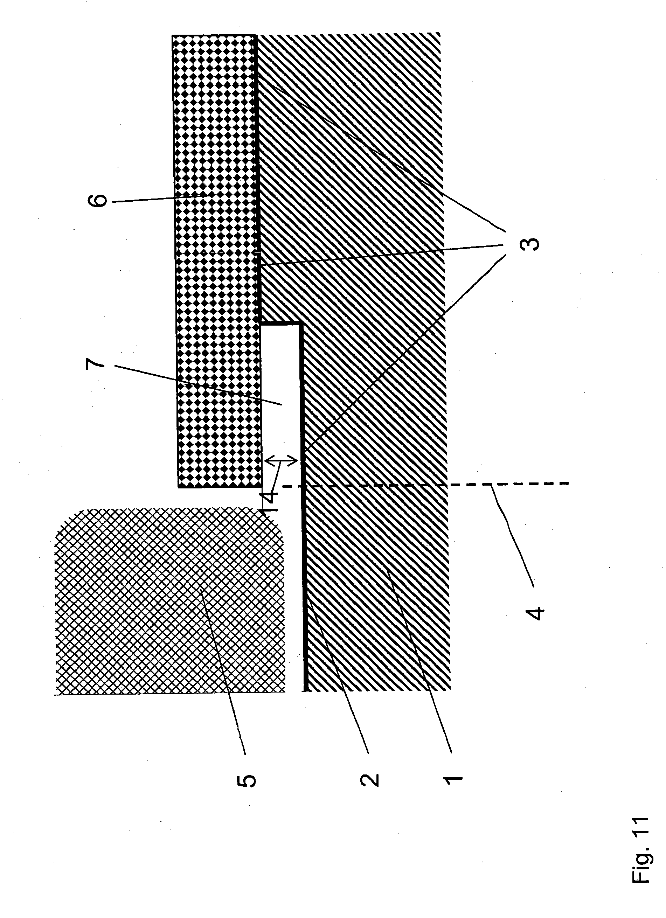

In Figur 11 weist die passive Oberfläche 3 eine Abschirmung aus einer Isolierstofflage 6 auf. Die Hohlkathode 1 zeigt hierbei einen stufenförmigen Verlauf. Die Randspalt-Weite 14 entspricht dem Abstand zwischen der Isolierstofflage 6 und der passiven Oberfläche 3. Die Tiefe des Randspaltes 7 wird durch den Abstand zwischen dem Lot 4 und der passiven Oberfläche 3 beschrieben. Das Plasma 5 liegt benachbart zur aktiven Oberfläche 2 der Hohlkathode 1 vor. Die Tiefe des Randspaltes 7 beträgt das Vierfache der Randspalt-Weite 14.

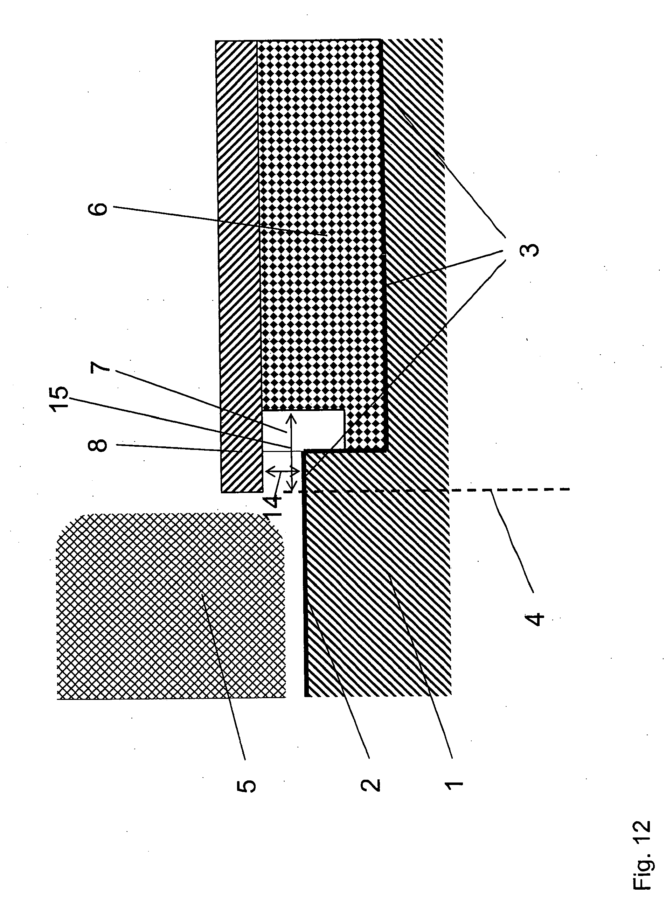

In Figur 12 ist eine stufenförmige passive Oberfläche 3 dargestellt. Die Abschirmung ist aus einer stufenförmigen Isolierstofflage 6 mit einer metallischen Schutzlage 8 aufgebaut. Der Randspalt 7 ist hier abgewinkelt. Die Randspalt-Tiefe 15 entspricht dem Abstand zwischen dem Lot 4 sowie der Isolierstofflage 6. Die Randspalt-Weite 14 entspricht dem Abstand zwischen der metallischen Schutzlage 8 sowie der passiven Oberfläche 3. Benachbart zur aktiven Oberfläche 2 liegt das Plasma 5 vor. Durch den abgewinkelten Randspalt 7 sind die äußeren Berührungspunkte von der Isolierstofflage 6 sowie der passiven Oberfläche 3 besonders gut vor einer Beschichtung oder Schädigung durch das Plasma 5 geschützt.

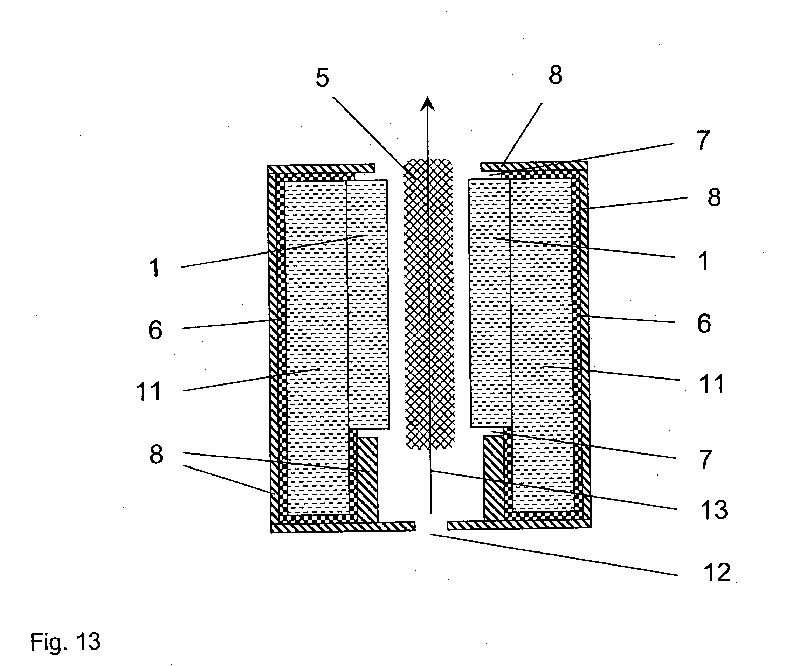

Figur 13 zeigt einen Querschnitt durch eine Hohlkathoden-Plasmaquelle mit einer Abschirmung aus Isolierstofflage 6, die durch eine metallische Schutzlage 8 abgedeckt ist. Hier liegen Randspalte zwischen der metallischen Schutzlage 8 sowie der Hohlkathode 1 vor. Die Isolierstofflage 6 ist auf dem der Hohlkathode 1 abgewandten Kathodenkühlkörper 11 angeordnet. Durch die Gaseinströmöffnung gelangt das Gas in die Gasströmung 13. Das Plasma 5 liegt innerhalb der Hohlkathode 1 vor. Die Randspalt-Weite 14 beträgt 10% der Hohlkathoden-Weite. Die Randspalt-Tiefe 15 beträgt das 2,5-fache der Randspalt-Weite 14.

## Patentansprüche

1. Hohlkathoden-Plasmaquelle mit einer Abschirmung der nicht für die Plasmaerzeugung genutzten Bereiche der Hohlkathode
(1) und der mit ihr elektrisch verbundenen Teile gegenüber dem Plasma (5), wobei die Hohlkathode (1) für die Plasmaerzeugung genutzte Oberflächen, i.e. aktive Oberflächen (2) und für die Plasmaerzeugung nicht-genutzte Oberflächen, i.e. passive Oberflächen (3) aufweist und die passiven Oberflächen (3) der Hohlkathode zumindest bereichsweise mit einer Abschirmung aus mindestens einer Isolierstofflage (6) oder einer Abschirmung aus mindestens einer Isolierstofflage (6) mit mindestens einer metallischen Schutzlage (8) versehen sind,**dadurch gekennzeichnet,dass** im zur aktiven Oberfläche
(2) benachbarten Randbereich der passiven Oberfläche
(3) die Abschirmung unter Ausbildung eines Randspaltes
(7) zur passiven Oberfläche beabstandet ist.

2. Hohlkathoden-Plasmaquelle gemäß dem vorhergehenden Anspruch,**dadurch gekennzeichnet, dass** der Randspalt (7) zwischen der Isolierstofflage (6) und der passiven Oberfläche (3) durch eine Ausnehmung in der Isolierstofflage gebildet ist.

3. Hohlkathoden-Plasmaquelle gemäß einem der vorhergehenden Ansprüche,**dadurch gekennzeichnet, dass** der Randspalt (7) zwischen der metallischen Schutzlage (8) und der passiven Oberfläche (3) gebildet ist, indem in diesem Bereich die Isolierstofflage (6) entfernt ist.

4. Hohlkathoden-Plasmaquelle gemäß einem der vorhergehenden Ansprüche,**dadurch gekennzeichnet, dass** eine Hohlkathoden-Weite bei runden, röhrenförmigen Hohlkathoden dem inneren Durchmesser der Hohlkathode entspricht und dass eine Hohlkathoden-Weite bei linearen Hohlkathoden, die aus zwei Platten gebildet sind, dem Abstand zwischen den zwei Platten entspricht.

5. Hohlkathoden-Plasmaquelle gemäß einem der vorhergehenden Ansprüche,**dadurch gekennzeichnet, dass** eine Spaltweite als Abstand zwischen der Abschirmung und der nicht im Bereich des Randspalts (7) vorliegenden passiven Oberfläche (3) gewählt ist, die höchstens 8 mm, bevorzugt höchstens 2 mm und besonders bevorzugt gleich null ist.

6. Hohlkathoden-Plasmaquelle gemäß einem der vorhergehenden Ansprüche,**dadurch gekennzeichnet, dass** der Randspalt (7) eine Randspalt-Weite (14) zwischen der Abschirmung und der passiven Oberfläche (3) zwischen 0,5 mm und 8 mm aufweist.

7. Hohlkathoden-Plasmaquelle gemäß einem der Ansprüche 4 bis 6,**dadurch gekennzeichnet, dass** der Randspalt (7) eine Randspalt-Weite (14) zwischen der Abschirmung und der passiven Oberfläche (3) zwischen 0,5 mm und höchstens 30 % der Hohlkathoden-Weite, bevorzugt höchstens 20 % der Hohlkathoden-Weite, besonders bevorzugt 10 % der Hohlkathoden-Weite aufweist.

8. Hohlkathoden-Plasmaquelle gemäß Anspruch 6 oder 7,**dadurch gekennzeichnet, dass** der Randspalt (7) eine Randspalt-Tiefe (15) zwischen der Abschirmung und einem Lot, das zwischen der aktiven Oberfläche (2) und der passiven Oberfläche (3) gefällt ist, aufweist, die mindestens den einfachen Wert, bevorzugt mindestens den eineinhalbfachen Wert, besonders bevorzugt den mindestens zweifachen Wert der Randspalt-Weite (14) aufweist.

9. Hohlkathoden-Plasmaquelle gemäß Anspruch 8, **dadurch gekennzeichnet, dass** die Randspalt-Tiefe (15) höchstens den fünffachen, bevorzugt höchstens den dreifachen Wert der Randspalt-Weite (14) aufweist.

10. Hohlkathoden-Plasmaquelle gemäß einem der Ansprüche 6 bis 9,**dadurch gekennzeichnet, dass** die Abschirmung im Bereich des Randspalts (7) einen stufigen oder stetigen Verlauf aufweist, wobei die Randspalt-Weite (14) einer mittleren Randspalt- Weite (14) gleichzusetzen ist.

11. Hohlkathoden-Plasmaquelle gemäß einem der vorhergehenden Ansprüche, **dadurch gekennzeichnet, dass** die Abschirmung mindestens einen Zusatzspalt (9) aufweist, der in Richtung eines Lots (4), das zwischen der aktiven Oberfläche (2) und der passiven Oberfläche (3) gefällt ist, geöffnet ist.

12. Hohlkathoden-Plasmaquelle gemäß einem der vorhergehenden Ansprüche,**dadurch gekennzeichnet, dass** die metallische Schutzlage (8) auf der Isolierstofflage (6) direkt aufliegt oder zwischen der metallischen Schutzlage (8) und der Isolierstofflage (6) ein Abstand im Bereich von 2 mm bis 10 mm vorliegt.

13. Hohlkathoden-Plasmaquelle gemäß einem der vorhergehenden Ansprüche,**dadurch gekennzeichnet, dass** die Hohlkathoden-Plasmaquelle eine Anode (10) aufweist, die elektrisch isoliert von der metallischen Schutzlage (8) auf der Isolierstofflage (6) angeordnet ist, wobei der Abstand zwischen der metallischen Schutzlage und der Anode mindestens 1 mm beträgt.

14. Hohlkathoden-Plasmaquelle gemäß einem der vorhergehenden Ansprüche,**dadurch gekennzeichnet, dass** die Isolierstofflage (6) eine Dicke von mindestens 0,05 mm, bevorzugt 0,5 mm bis 5 mm, besonders bevorzugt 1 mm bis 3 mm aufweist.

15. Hohlkathoden-Plasmaquelle gemäß einem der vorhergehenden Ansprüche,**dadurch gekennzeichnet, dass** die Isolierstofflage (6) ausgewählt ist aus Glas, Keramik, natürlichen Mineralien, insbesondere Glimmer, Kunststoff, bevorzugt Hochleistungskunststoff, besonders bevorzugt Teflon, Polyetheretherketon (PEEK), biaxial orientierter Polyesterfolie (boPET), Polyphenylensulfid (PPS), Polyphenylenether (PPE), Polyimiden, Hartpapier, Hartgewebe, körnigen Partikeln, pulverförmigen Partikeln und/oder Mischungen hiervon.

16. Hohlkathoden-Plasmaquelle gemäß einem der vorhergehenden Ansprüche,**dadurch gekennzeichnet, dass** die metallische Schutzlage (8) eine Dicke von mindestens 0,05 mm, bevorzugt von 0,3 mm bis 20 mm, besonders bevorzugt von 0,5.bis 2 mm aufweist.

17. Hohlkathoden-Plasmaquelle gemäß einem der vorhergehenden Ansprüche,**dadurch gekennzeichnet, dass** die metallische Schutzlage (8) aus Metall, insbesondere Aluminium, Titan, Kupfer, Nickel, Legierungen, insbesondere Chrom-Nickel-Stahl besteht oder diese enthält.

18. Verwendung der Hohlkathoden-Plasmaquelle gemäß einem der Ansprüche 1 bis 17 zur Oberflächenbehandlung von Hohlräumen und konkav geformten Oberflächen, insbesondere von Rohren und Lagern, von Bauteilen von Turbinen, Gasturbinen, Dampfturbinen, Verdichtern, insbesondere Schaufelblättern, Bauteilen von Verbrennungsmotoren und deren Abgassystemen, Katalysatoren, mikroelektronischen, mikromechanischen und medizintechnischen Bauteilen, Mikrobauelementen mit Piezotechnik, insbesondere Blei-Zirkonat-Titanat (PZT), medizinischen Implantaten, Dental-Implantaten, Solarzellen, amorphem Silicium (a-Si:H), Hartstoffen für Werkzeuge.

19. Verwendung der Hohlkathoden-Plasmaquelle gemäß einem der Ansprüche 1 bis 17 zur Herstellung von Metallschichten, Oxidschichten, Nitridschichten, kohlenstoffhaltigen Schichten, insbesondere für tribologische, elektrische, optische, elektromechanische, elektrooptische, medizinische und katalytische Anwendungen, als Barriere- und Korrosionsschutzschichten, transparentem Kratzschutz, transparente leitfähige Beschichtungen (TCO, transparent conductive coatings), Festoxidbrennstoffzellen (SOFC, solid oxid fuel cell).

## Claims

1. Hollow cathode plasma source with screening of the regions of the hollow cathode (1) which are not used for plasma production and of the parts which are connected electrically thereto relative to the plasma (5), the hollow cathode (1) having surfaces which are used for the plasma production, i.e. active surfaces (2), and surfaces which are not used for the plasma production, i.e. passive surfaces (3), and the passive surfaces (3) of the hollow cathode being provided at least in regions with a screen made of at least one insulation material layer (6), or with a screen made of at least one insulation material layer (6) with at least one metallic protective layer (8), **characterised in that**, in the edge region of the passive surface (3), which is adjacent to the active surface (2), the screen is at a spacing relative to the passive surface with formation of an edge gap (7).

2. Hollow cathode plasma source according to the preceding claim, **characterised in that** the edge gap (7) is formed between the insulation material layer (6) and the passive surface (3) by a recess in the insulation material layer.

3. Hollow cathode plasma source according to one of the preceding claims, **characterised in that** the edge gap (7) is formed between the metallic protective layer (8) and the passive surface (3) by the insulation material layer (6) being removed in this region.

4. Hollow cathode plasma source according to one of the preceding claims, **characterised in that** a hollow cathode width corresponds, in the case of round, tubular hollow cathodes, to the internal diameter of the hollow cathode and **in that** a hollow cathode width, in the case of linear hollow cathodes which are formed from two plates, corresponds to the spacing between the two plates.

5. Hollow cathode plasma source according to one of the preceding claims, **characterised in that** a gap width is chosen as spacing between the screen and the passive surface (3) which is not present in the region of the edge gap (7), which gap width is at most 8 mm, preferably at most 2 mm and particularly preferred equal to zero.

6. Hollow cathode plasma source according to one of the preceding claims, **characterised in that** the edge gap (7) has an edge gap width (14) between the screen and the passive surface (3) between 0.5 mm and 8 mm.

7. Hollow cathode plasma source according to one of the claims 4 to 6, **characterised in that** the edge gap (7) has an edge gap width (14) between the screen and the passive surface (3) between 0.5 mm and at most 30% of the hollow cathode width, preferably at most 20% of the hollow cathode width, particularly preferred 10% of the hollow cathode width.

8. Hollow cathode plasma source according to claim 6 or 7, **characterised in that** the edge gap (7) has an edge gap depth (15) between the screen and solder which is deposited between the active surface (2) and the passive surface (3) and has at least once the value, preferably at least one and a half times the value, particularly preferred at least twice the value of the edge gap width (14).

9. Hollow cathode plasma source according to claim 8, **characterised in that** the edge gap depth (15) has at most five times, preferably at most three times the value of the edge gap width (14)

10. Hollow cathode plasma source according to one of the claims 6 to 9, **characterised in that** the screen in the region of the edge gap (7) has a graduated or constant course, the edge gap width (14) requiring to be made equal to an average edge gap width (14).

11. Hollow cathode plasma source according to one of the preceding claims, **characterised in that** the screen has at least one additional gap (9) which is opened in the direction of solder (4) which is deposited between the active surface (2) and the passive surface (3).

12. Hollow cathode plasma source according to one of the preceding claims, **characterised in that** the metallic protective layer (8) abuts directly on the insulation material layer (6) or a spacing in the range of 2 mm to 10 mm is present between the metallic protective layer (8) and the insulation material layer (6).

13. Hollow cathode plasma source according to one of the preceding claims, **characterised in that** the hollow cathode plasma source has an anode (10) which is disposed, electrically insulated from the metallic protective layer (8), on the insulation material layer (6), the spacing between the metallic protective layer and the anode being at least 1 mm.

14. Hollow cathode plasma source according to one of the preceding claims, **characterised in that** the insulation material layer (6) has a thickness of at least 0.05 mm, preferably 0.5 mm to 5 mm, particularly preferred 1 mm to 3 mm.

15. Hollow cathode plasma source according to one of the preceding claims, **characterised in that** the insulation material layer (6) is selected from glass, ceramic, natural minerals, in particular mica, plastic material, preferably high-performance plastic material, particularly preferred Teflon, polyether ether ketone (PEEK), biaxially orientated polyester film (boPET), polyphenylene sulphide (PPS), polyphenylene ether (PPE), polyimides, hard paper, hard fabric, grainy particles, pulverulent particles and/or mixtures hereof.

16. Hollow cathode plasma source according to one of the preceding claims, **characterised in that** the metallic protective layer (8) has a thickness of at least 0.05 mm, preferably of 0.3 mm to 20 mm, particularly preferred of 0.5 to 2 mm.

17. Hollow cathode plasma source according to one of the preceding claims, **characterised in that** the metallic protective layer (8) consists of metal, in particular aluminium, titanium, copper, nickel, alloys, in particular chromium-nickel steel or comprises these.

18. Use of the hollow cathode plasma source according to one of the claims 1 to 17 for surface treatment of cavities and concavely shaped surfaces, in particular of pipes and bearings, of components of turbines, gas turbines, steam turbines, compressors, in particular blades, components of internal combustion engines and the exhaust systems thereof, catalysts, microelectronic, micromechanical and medical-technical components, microcomponents with piezo technology, in particular lead-zirconate-titanate (PZT), medical implants, dental implants, solar cells, amorphous silicon (a-Si:H), hard materials for tools.

19. Use of the hollow cathode plasma source according to one of the claims 1 to 17 for the production of metal layers, oxide layers, nitride layers, carbon-containing layers, in particular for tribological, electrical, optical, electromechanical, electrooptical, medical and catalytic applications, as barrier- and corrosion-protection layers, transparent scratch protection, transparent conductive coatings (TCO), solid oxide fuel cells (SOFC).

## Revendications

1. Source de plasma à cathode creuse, comportant un blindage contre le plasma (5) pour les zones de la cathode creuse (1) non utilisées pour générer le plasma et les parties électriquement reliées à celle-ci, la cathode creuse (1) comportant des surfaces utilisées pour générer le plasma, c'est-à-dire des surfaces actives (2) et des surfaces non utilisées pour générer le plasma, c'est-à-dire des surfaces passives (3), et lesdites surfaces passives (3) de la cathode creuse étant munies au moins par zones d'un blindage constitué d'au moins une couche de matière isolante (6) ou un blindage constitué d'au moins une couche de matière isolante (6) avec au moins une couche de protection métallique (8), **caractérisée en ce que** dans la zone de bordure de la surface passive (3), laquelle zone est adjacente à la surface active (2), le blindage est situé à distance de la surface passive moyennant la formation d'une fente marginale (7).

2. Source de plasma à cathode creuse selon la revendication précédente, **caractérisée en ce que** la fente marginale (7) est formée par un évidement dans la couche de matière isolante entre la couche de matière isolante (6) et la surface passive (3).

3. Source de plasma à cathode creuse selon l'une quelconque des revendications précédentes, **caractérisée en ce que** la fente marginale (7) est formée entre la couche de protection métallique (8) et la surface passive (3), du fait que la couche de matière isolante (6) a été enlevée dans cette zone.

4. Source de plasma à cathode creuse selon l'une quelconque des revendications précédentes, **caractérisée en ce que** dans des cathodes creuses tubulaires rondes, une largeur de la cathode creuse correspond au diamètre intérieur de la cathode creuse, et **en ce que** dans des cathodes creuses linéaires, formées de deux plaques, une largeur de la cathode creuse correspond à la distance entre les deux plaques.

5. Source de plasma à cathode creuse selon l'une quelconque des revendications précédentes, **caractérisée en ce que** pour former la distance entre le blindage et la surface passive (3) non située dans la zone de la fente marginale (7), on choisit une largeur de fente qui mesure au maximum 8 mm, de préférence au maximum 2 mm et de manière particulièrement préférée est égale à zéro.

6. Source de plasma à cathode creuse selon l'une quelconque des revendications précédentes, **caractérisée en ce que** la fente marginale (7) possède entre le blindage et la surface passive (3) une largeur de fente (14) mesurant entre 0,5 mm et 8 mm.

7. Source de plasma à cathode creuse selon l'une quelconque des revendications 4 à 6, **caractérisée en ce que** la fente marginale (7) possède entre le blindage et la surface passive (3) une largeur de fente (14) mesurant entre 0,5 mm et au maximum 30 % de la largeur de la cathode creuse, de préférence au maximum 20 % de la largeur de la cathode creuse, de manière particulièrement préférée 10 % de la largeur de la cathode creuse.

8. Source de plasma à cathode creuse selon les revendications 6 ou 7, **caractérisée en ce que** la fente marginale (7) possède entre le blindage et une verticale, tracée entre la surface active (2) et la surface passive (3), une profondeur (15) ayant une valeur correspondant au moins à une fois, de préférence au moins à une fois et demie, de manière particulièrement préférée au moins à deux fois la valeur de la largeur (14) de la fente marginale.

9. Source de plasma à cathode creuse selon la revendication 8, **caractérisée en ce que** la profondeur (15) de la fente marginale correspond au maximum à cinq fois, de préférence au maximum à trois fois la valeur de la largeur (14) de la fente marginale.

10. Source de plasma à cathode creuse selon l'une quelconque des revendications 6 à 9, **caractérisée en ce que** le blindage dans la zone de la fente marginale (7) présente un tracé étagé ou continu, la largeur (14) de la fente marginale pouvant être assimilée à une largeur (14) moyenne de la fente marginale.

11. Source de plasma à cathode creuse selon l'une quelconque des revendications précédentes, **caractérisée en ce que** le blindage comporte au moins une fente supplémentaire (9) qui est ouverte vers une verticale (4) tracée entre la surface active (2) et la surface passive (3).

12. Source de plasma à cathode creuse selon l'une quelconque des revendications précédentes, **caractérisée en ce que** la couche de protection métallique (8) est appliquée directement sur la couche de matière isolante (6) ou une distance dans une plage de 2 mm à 10 mm existe entre la couche de protection métallique (8) et la couche de matière isolante (6).

13. Source de plasma à cathode creuse selon l'une quelconque des revendications précédentes, **caractérisée en ce que** la source de plasma à cathode creuse comporte une anode (10) qui, électriquement isolée de la couche de protection métallique (8), est disposée sur la couche de matière isolante (6), la distance entre la couche de protection métallique et l'anode mesurant au moins 1 mm.

14. Source de plasma à cathode creuse selon l'une quelconque des revendications précédentes, **caractérisée en ce que** la couche de matière isolante (6) possède une épaisseur d'au moins 0,05 mm, de préférence de 0,5 mm à 5 mm, de manière particulièrement préférée de 1 mm à 3 mm.

15. Source de plasma à cathode creuse selon l'une quelconque des revendications précédentes, **caractérisée en ce que** la couche de matière isolante (6) est choisie parmi le verre, la céramique, les minéraux naturels, en particulier le mica, la matière plastique, de préférence une matière plastique de haute performance, de manière particulièrement préférée le téflon, le polyétheréthercétone (PEEK), la feuille de polyester bi-orienté (boPET), le polysulfure de phénylène (PPS), le polyphénylène éther (PPE), les polyimides, le papier bakélisé, la toile bakélisée, les particules granulaires, les particules pulvérulentes et/ou des mélanges de ceux-ci.

16. Source de plasma à cathode creuse selon l'une quelconque des revendications précédentes, **caractérisée en ce que** la couche de projection métallique (8) a une épaisseur d'au moins 0,05 mm, de préférence de 0,3 mm à 20 mm, de manière particulièrement préférée de 0,5 mm à 2 mm.

17. Source de plasma à cathode creuse selon l'une quelconque des revendications précédentes, **caractérisée en ce que** la couche de protection métallique (8) est réalisée en métal, en particulier l'aluminium, le titane, le cuivre, le nickel, des alliages, en particulier un acier au chrome et nickel, ou contient ceux-ci.

18. Utilisation de la source de plasma à cathode creuse selon l'une quelconque des revendications 1 à 17, pour le traitement de surface des cavités et des surfaces à forme concave, en particulier des tubes et des paliers, des pièces de turbines, des turbines à gaz, des turbines à vapeur, des compresseurs, en particulier des pales, des pièces de moteurs à combustion interne et leurs systèmes d'échappement, des catalyseurs, des pièces de micro-électricité, de micromécanique et de technique médicale, des microéléments avec une technique piézoélectrique, en particulier des céramiques de titano-zirconate de plomb (PZT), des implants médicaux, des implants dentaires, des cellules solaires, du silicium amorphe (a-Si:H), des matériaux à résistance mécanique élevée pour outils.

19. Utilisation de la source de plasma à cathode creuse selon l'une quelconque des revendications 1 à 17, pour la réalisation de couches métalliques, de couches oxydes, de couches de nitrures, de couches contenant du carbone, en particulier pour des applications tribologiques, électriques, optiques, électromécaniques, électro-optiques, médicales et catalytiques, en tant que couches barrières et couches de protection contre la corrosion, des protections transparentes contre les griffures, des revêtements transparents conducteurs (TCO, transparent conductive coatings), des piles à combustible à oxyde solide (SOFC, solid oxid fuel cell).
